Europäisches Patentamt

European Patent Office

Office européen des brevets

(11) Publication number : **0 450 866 A2**

(12) **EUROPEAN PATENT APPLICATION**

(21) Application number : 91302730.6

(51) Int. Cl.⁵ : **G11C 27/02**

(22) Date of filing : 27.03.91

(30) Priority : **03.04.90 GB 9007492**

(43) Date of publication of application :
**09.10.91 Bulletin 91/41**

(84) Designated Contracting States :
**AT BE CH DE DK ES FR GB IT LI LU NL SE**

(71) Applicant : **Pilkington Micro-Electronics
Limited
Prescot Road St. Helens
Merseyside WA10 3TT (GB)**

(72) Inventor : **Austin, Kenneth
Brockhurst Hall, Brockhurst Way
Northwich, Cheshire CW9 8AP (GB)**

(74) Representative : **Palmer, Roger et al
PAGE, WHITE & FARRER 54 Doughty Street
London WC1N 2LS (GB)**

(54) Semiconductor capacitor circuit.

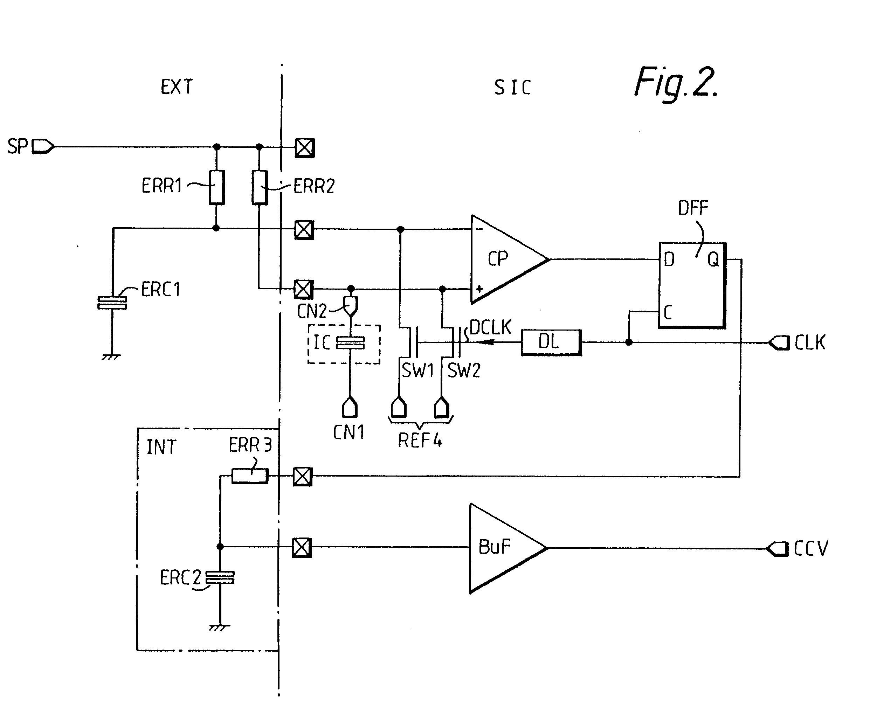

(57)    This invention relates to semiconductor integrated circuits concerned with the realisation of different value capacitive components of a semiconductor chip by means of programming control arrangements. Programmable (IC) capacitors are implemented using a capacitive multiplier technique. Programmable capacitors comprise essentially three elements, a capacitor (C1) and one or two capacitor multipliers (M1 and M2). Capacitor (C1) is connected to the output of a first buffer circuit (B1) while programmable resistors (RP1 and RP2) are connected in series between the input and output of the buffer (B1), an output being taken from the junction between the first and second programmable resistors. By this arrangement of components, the ratio of the set values of the two programmable resistors (RP2 and RP1) determines the amount by which the capacitor (C1) value is multiplied. An overall effective capacitance value equal to (RP2/RP1) x C1 may be achieved. The final effective capacitance with two multipliers (M1, M2) approximates to (RP2/RP1) x (RP4/RP3) x C1. The value of programmable resistor RP1 is adjusted in accordance with an analogue reference signal (CCV) produced by a compensating circuit (Fig 2) to compensate for the manufacturing/processing variations of capacitor C1.

EP 0 450 866 A2

Jouve, 18, rue Saint-Denis, 75001 PARIS

Fig.1.

The present invention relates to semiconductor integrated circuits and is particularly concerned with the realisation of different value capacitive components on a semiconductor chip by means of programming control arrangements.

This invention may be used, typically within a semiconductor integrated circuit which is concerned with a configurable analogue array. Such an array, may comprise a plurality of analogue cells arranged in rows and columns, each cell incorporates components (eg resistors and capacitors) which, of necessity, from time to time require value changing during an array configuration process.

Hitherto, using conventional techniques to fabricate capacitors on a semiconductor chip, has presented the designer with difficulties in obtaining capacitors of a sufficiently high value. Additionally it is always difficult to obtain accurate values within specific tolerances because of the effects of variations introduced during chip manufacture/processing operations.

An aim of this invention is to overcome these difficulties by providing a semiconductor integrated circuit which is capable of accurately realising a plurality of different value capacitors by means of a programming operation.

According to this invention there is provided a semiconductor integrated circuit adapted to produce a programmable capacitor comprising, a capacitor, first and second programmable resistors, and a compensating circuit, wherein by means of an impedance conversion process relative to the ratio of the first and second programmable resistors the effective value of the capacitor is multiplied and wherein the compensating circuit is operable to adjust the first programmable resistor to compensate for variations in the value of the capacitor and the second programmable resistor is operable to effect the capacitance multiplication to the required value.

Preferably the capacitor is fabricated within the semiconductor integrated circuit.

The programmable capacitor is preferably a capacitor multiplier arrangement which includes a first buffer circuit having a high impedance input and a low impedance output and wherein the capacitor is connected to the high impedance input and the first and second programmable resistors are connected in series between the input and output of the first buffer circuit, the first programmable resistor being connected to the low impedance output of the first buffer circuit and the output from the capacitor multiplier being taken from the junction between the first and second programmable resistors.

The capacitor value is preferably multiplied by an amount which is determined by the ratio of the value of the second resistor to the value of the first resistor, and an overall effective capacitance value is substantially equal to the ratio of the second programmable resistor to the first programmable resistor multiplied by the value of the capacitor.

The programmable capacitor may comprise two capacitor multiplier arrangements connected in series.

The compensating circuit preferably comprises two separate substantially identical capacitor/resistor time constant circuits, a first of which comprises an external capacitor and resistor both of which are of known and accurate value and the second of which comprises a programmable capacitor having a set value approximately equal to the external capacitor and a known accurate value external resistor.

Preferably the compensating circuit includes a timing circuit comprising switch means adapted to repeatedly charge and discharge the two time constant circuits, a comparator means adapted to compare the charging rate of the programmable capacitor and the external capacitor and to provide an output signal indicative of which charging rate is the fastest, storage means for storing the output signal and integrator means for integrating successive output signals and provide an appropriate analogue reference signal to control the adjustment of the first programmable resistor.

Preferably the storage means is a flip-flop controlled by a clock signal.

The timing circuit preferably additionally includes a delay means wherein the delay means is arranged to produce a delayed clock signal, the delayed clock signal being employed to control the repetitive switching of the switch means.

Preferably a second buffer circuit is employed on the output of the integrator circuit.

The analogue reference signal is preferably converted to a digital signal by analogue-to-digital converter means incorporated between the output of the second buffer circuit and the input for controlling the circuit for controlling the first programmable resistor.

The invention will be more readily understood from the following description of an exemplary embodiment which should be read in conjunction with the accompanying drawings, in which:

Fig 1 shows a schematic diagram of a capacitor multiplier circuit;

Fig 2 shows a schematic diagram of a capacitor compensating circuit; and

Fig 3 shows a detailed circuit diagram of an analogue buffer as employed in the circuit of Fig 1.

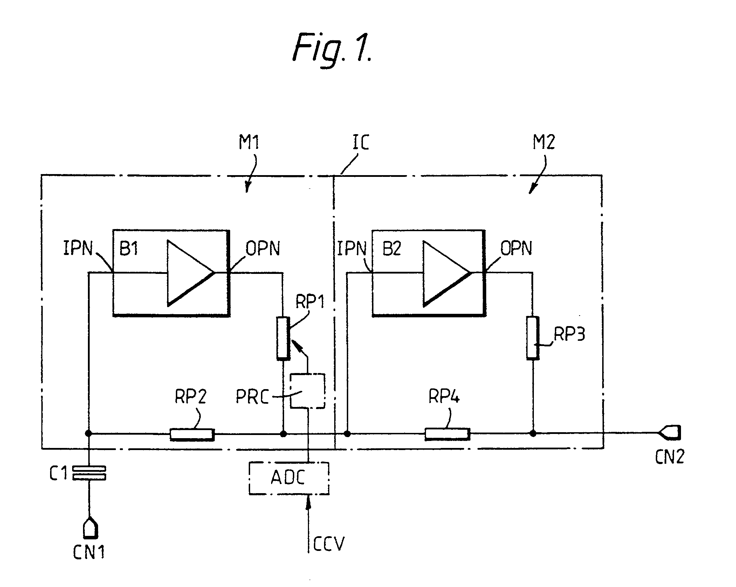

Referring to the drawings and particularly to Fig 1 which illustrates a programmable capacitor circuit, it should be appreciated that capacitors are implemented using a capacitive multiplier technique. Programmable capacitors comprise essentially three elements, a capacitor C1 and one or two capacitor multipliers M1 and M2. These are shown connected between nodes CN1 and CN2.

As it is not possible to fabricate one hundred 5E-9 Farad capacitors, a small capacitor C1 (5E-12 Farad) is fabricated and the equivalent of the required capacitor value is then generated by a process of impedance conversion. This is explained as follows: signals driving into node CN1 see an impedance that approximates to RP2, whereas signals that drive into the junction of RP1 and RP2 see an impedance that approximates to RP1. The impedance conversion results from the presence of the buffer B1 which has a high input impedance relative to its output impedance.

The 5E-12 Farad capacitor C1 is connected to the input of a first buffer circuit B1. Programmable resistors RP1 and RP2 (resistors whose values may be changed as required) are connected in series between the input and output of the first buffer circuit B1, an output being taken from the junction between the first and second programmable resistors. By this arrangement of components, the ratio of the set values of the two programmable resistors RP2 and RP1 determines the amount by which the capacitor (C1) value is multiplied.

The set value of resistor RP2 is higher than the set value of resistor RP1, therefore, the effect at the junction of resistors RP1 and RP2 is multiplication, and an overall effective capacitance value equal to (RP2/RP1) x C1. The effective capacitance at the junction of resistors RP1 and RP2 is further multiplied by the second stage multiplier M2, including programmable resistors RP3 and RP4 and a buffer B2. Thus, the final effective capacitance at the junction of resistors RP3 and RP4 approximates to (RP2/RP1) x (RP4/RP3) x C1. This second stage multiplication is necessary if higher value capacitors are required in order to avoid the effects of parasitic capacitance present in the higher value programmable resistors required to produce a higher value capacitor.

Programmable resistors RP2 and RP4 are utilised for programming the final capacitance while resistor RP1 is driven by a reference signal CCV (see Fig 1 and Fig 2) to compensate for the manufacturing/processing variations of capacitor C1.

The main drawback of this type of circuit is that high Q capacitors cannot be produced. For most applications for capacitors produced in this manner, however, this is not a major problem since the capacitor multiplier has a series resistance that approximates to the value of resistor RP3.

The capacitor compensating circuit shown in Fig 2, including an external section EXT and a semiconductor integrating circuit section SIC, is arranged to provide a capacitor multiplier voltage reference control signal CCV which controls the programmable resistor RP1. In this way, the variations in oxide thickness of the 5E-12 farad capacitor C1 are automatically compensated for.

A supply voltage is applied to terminal SP, and in operation it is arranged for a timing circuit to compare the time constants of two separate but substantially identical capacitor/resistor circuits. One time constant circuit employs an accurate external capacitor ERC1 of 5E-9 farads in series with a known accurate value, external resistor ERR1 and the other time constant circuit employs an internal capacitor IC (of the type shown in Fig 1) of 5E-9 farad (generated by multiplication of an internal capacitor of 5E-12 farads) in series with an external resistor ERR2.

It is arranged that the two capacitors IC and ERC1 are charged and discharged repeatedly by switching the switches SW1 and SW2 under control of clock signals DCLK which is the clock signal CLK delayed by the delay DL. The connectors REF4 on the switches SW1 and SW2 are conveniently connected to zero volts.

At the time of the delayed clock signals DCLK, the comparator CP repeatedly compares the voltages across each of the capacitors IC and ERC1 to determine which of the capacitors is charging up the fastest and the resultant output from the comparator is latched/stored by the 'D' type flip-flop DFF.

At the actual time of the clock signals CLK, the output Q from the flip-flop DFF (the previous signal comparison output corresponding to the time of the immediately preceding clock signal CLK) is output to an integrator circuit INT comprising a further external capacitor ERC2 and a further external resistor ERR3, and this integrates successive output signals from Q. The output from the integrator circuit IC is fed through a second buffer circuit BUF to provide a reference signal CCV (an analogue signal) which provides a direct control for varying the value of resistor RP1 in the multiplier M1, and thereby change the ratio RP2/RP1 and hence the effective value of the capacitor IC.

It should be understood that the analogue signal CCV requires conversion to an equivalent digital form to be effective on the circuit to change the value of the resistor RP1. This may be achieved by a suitable analogue-to-digital converter ADC inserted between the output of the second buffer circuit BUF and the input to the circuit PRC for controlling the programmable resistor RP1.

Thus, in operation, an iterative process takes place whereby the integrator circuit continuously changes the analogue signal CCV which in turn changes the value of resistor RP1 and in turn the effective value of the internal capacitor IC. This process continues until the correct value capacitance is attained.

Explaining this further, if the internal capacitor IC charges up quicker than the external capacitor ERC1, then the reference voltage CCV is reduced. This has the effect of increasing the value of the internal capacitor IC by varying the ratio of the resistors RP1 and RP2 in the multiplier M1.

Alternatively if the external capacitor ERC1 charges up quicker than the internal capacitor IC, then the reference voltage CCV is increased. This has the effect of decreasing the value of the internal capacitor IC by varying the ratio of the resistors RP1 and RP2 in the multiplier M1.

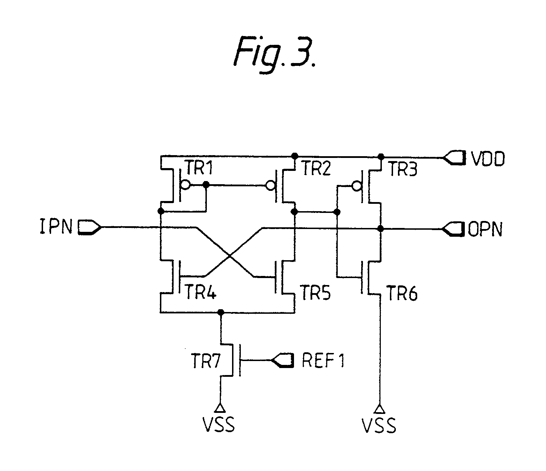

Referring now to Fig 3 which shows a detailed circuit diagram of a high impedance input, low impedance output unity gain buffer stage as employed in the multipliers M1 and M2 for first buffer circuits B1 and B2, the input is designated IPN and the output is designated OPN. These nodes are designated identically in both Fig 1 and Fig 2.

The buffer circuit comprises three P-type MOS transistors. TR1, TR2 and TR3 and three N-type MOS transistors TR4, TR5, TR6 and TR7. VSS and VDD represent the supply voltage for the circuit while REF1 represents a suitable reference bias voltage.

## Claims

1. A semiconductor integrated circuit adapted to produce a programmable capacitor, characterised in that the integrated circuit comprises, a capacitor (C1), first and second programmable resistors (RP1, RP2), and a compensating circuit (Fig 2), wherein by means of an impedance conversion process relative to the ratio of the first and second programmable resistors the effective value of the capacitor (C1) is multiplied and wherein the compensating circuit (Fig 2) is operable to adjust the first programmable resistor (RP1) to compensate for variations in the value of the capacitor (C1) and the second programmable resistor (RP2) is operable to effect the capacitance multiplication to the required value.

2. A semiconductor circuit as claimed in claim 1, wherein the capacitor (C1) is fabricated within the semiconductor integrated circuit.

3. A semiconductor integrated circuit as claimed in claim 1 or claim 2, wherein the programmable capacitor is a capacitor multiplier arrangement (M1) which includes a first buffer circuit (B1) having a high impedance input and a low impedance output and wherein the capacitor (C1) is connected to the high impedance input (IPN) and the first and second programmable resistors (RP1, RP2) are connected in series between the input (IPN) and output (OPN) of the first buffer circuit (B1), the first programmable resistor (RP1) being connected to the low impedance output (OPN) of the first buffer circuit (B1) and the output from the capacitor multiplier being taken from the junction between the first and second programmable resistors (RP1, RP2).

4. A semiconductor integrated circuit as claimed in any one preceding claim, wherein the capacitor value is multiplied by an amount which is determined by the ratio of the value of the second resistor (RP2) to the value of the first resistor (RP1), and an overall effective capacitance value is substantially equal to the ratio of the second programmable resistor (RP2) to the first programmable resistor (RP1) multiplied by the value of the capacitor (C1).

5. A semiconductor integrated circuit as claimed in claim 4, wherein the programmable capacitor comprises two capacitor multiplier arrangements (M1, M2) connected in series.

6. A semiconductor integrated circuit as claimed in claim 4 or claim 5 wherein the compensating circuit (Fig 2) comprises two separate substantially identical capacitor/resistor time constant circuits (IC, ERR2) (ERC1, ERR1), a first of which comprises an external capacitor (ERC1) and resistor (ERR1) both of which are of known and accurate value and the second of which comprises a programmable capacitor (IC) having a set value approximately equal to the external capacitor (ERC1) and a known accurate value external resistor (ERR2).

7. A semiconductor integrated circuit as claimed in claim 6, wherein the compensating circuit (Fig 2) includes a timing circuit comprising switch means (SW1, SW2) adapted to repeatedly charge and discharge the two time constant circuits, a comparator means (CP) adapted to compare the charging rate of the programmable capacitor (IC) and the external capacitor (ERC1) and to provide an output signal indicative of which charging rate is the fastest, storage means (DFF) for storing the output signal and integrator means (INT) for integrating successive output signals and provide an appropriate analogue reference signal (CCV) to control the adjustment of the first programmable resistor (RP1).

8. A semiconductor integrated circuit as claimed in claim 7, wherein the storage means (DFF) is a flip-flop controlled by a clock signal (CLK).

9. A semiconductor integrated circuit as claimed in claim 7 or claim 8, wherein the timing circuit preferably includes a delay means (DL) wherein the delay means (DL) is arranged to produce a delayed clock signal (DCLK), the delayed clock signal (DCLK) being employed to control the repetitive switching of the switch means (SW1, SW2).

**10.** A semiconductor integrated circuit as claimed in claim 9, wherein a second buffer circuit (BUF) is employed on the output of the integrator circuit (IC).

**11.** A semiconductor integrated circuit as claimed in claim 10, wherein the analogue reference signal (CCV) is converted to a digital signal by analogue-to-digital converter (ADC) means incorporated between the output of the second buffer circuit (BUF) and the input for controlling the circuit (PRC) for controlling the first programmable resistor.

# Fig.1.

Fig.2.

Fig.3.